# Europäisches Patentamt

## European Patent Office

## Office européen des brevets

(11) Veröffentlichungsnummer: **0 134 416**
**B1**

(12) **EUROPÄISCHE PATENTSCHRIFT**

(45) Veröffentlichungstag der Patentschrift:
03.05.89

(21) Anmeldenummer: **84106198.9**

(22) Anmeldetag: **30.05.84**

(51) Int. Cl.⁴: **B 29 C 67/14**

(54) Faserverstärkter Verbundwerkstoff sowie Verfahren zur Herstellung einer Verbundwerkstoff-Faser.

(30) Priorität: **01.07.83 DE 3323855**

(43) Veröffentlichungstag der Anmeldung:
**20.03.85 Patentblatt 85/12**

(45) Bekanntmachung des Hinweises auf die Patenterteilung:
**03.05.89 Patentblatt 89/18**

(84) Benannte Vertragsstaaten:
**CH FR GB LI SE**

(56) Entgegenhaltungen:
**AU-B- 456 990**
**DE-A- 1 761 776**
**FR-A- 1 151 648**
**FR-A- 2 391 067**
**GB-A- 2 108 558**
**US-A- 2 775 022**

(73) Patentinhaber: **MTU MOTOREN- UND TURBINEN-UNION MÜNCHEN GMBH, Dachauer**
**Strasse 665 Postfach 50 06 40, D-8000 München 50 (DE)**

(72) Erfinder: **Betz, Wolfgang, Dr.-Ing.,**
**Grubmühlerfeldstrasse 15, D-8035 Gauting (DE)**
Erfinder: **Hüther, Werner, Dr.-Ing.,**
**Nikolaus-Lenau-Strasse 8, D-8047 Karlsfeld (DE)**
Erfinder: **Merz, Herbert, Donauwörther-Strasse 21,**
**D-8000 München 50 (DE)**

## Beschreibung

Die Erfindung betrifft einen faserverstärkten Verbundwerkstoff mit Faser und Matrix sowie ein Verfahren zur Herstellung einer beim Verbundwerkstoff verwendeten Faser.

Faserverstärkte Verbundwerkstoffe sind im Vergleich zu metallischen Werkstoffen spröde, und zwar umso spröder, je spröder die Faser, die Matrix und/oder die Grenzflächen Faser/Matrix sind.

Andererseits sind aber für die Anwendung im Bereich höherer oder hoher Temperaturen nur relativ spröde Faser- und Matrix-Werkstoffe einsetzbar. Darüber hinaus ist eine hohe Haftung der Grenzfläche Faser/Matrix unabdingbar, da andernfalls keine Scherbeanspruchungen zwischen der lasttragenden Faser und der lastübertragenden Matrix möglich sind, d.h. im Extremfall des Bruches würden die Fasern aus der Matrix herausgezogen. Diese – erwünschte – hohe Haftfestigkeit hat jedoch den Nachteil, daß ein in der (spröden) Matrix quer zur Faser laufender Riß in der Faser eine hohe lokale Kerbkonzentration verursacht. Deshalb bricht die Faser, ohne eine – bei geringer Grenzflächenhaftung mögliche – Rißstopperwirkung zu entfalten.

Aus der GB-A 2 108 508 ist ein gattungsgemäßer Verbundwerkstoff bekannt geworden, bei dem ein Teil der Fasern große Haftung mit der sie umgebenden Matrix aufweist, während der andere Teil der Fasern geringe Haftung aufweist, um einerseits eine hohe Zugfestigkeit und Steifigkeit, andererseits hohe Bruchzähigkeit zu erzielen. Dabei tritt jedoch der Nachteil auf, daß eine Rißstoppwirkung durch die stark haftenden Fasern nicht erzielbar ist, sondern ein Riß sich durch die gesamte, steife Matrix ausbreiten kann, während die niedrig haftenden Fasern keinerlei günstige Wirkung entfalten.

Aufgabe der Erfindung ist die Schaffung eines faserverstärkten Verbundwerkstoffs und insbesondere eine Verbundwerkstoff-Faser sowie ein Faserherstellverfahren wobei bei der Faser einerseits die Grenzflächenhaftung so hoch gehalten ist, daß die Fähigkeit der Faser zur Lastübertragung vollgenutzt werden kann, andererseits jedoch auch eine ausreichende Rißstoppwirkung an der Grenzfläche erzielt wird.

Gelöst wird die der Erfindung zugrundeliegende Aufgabe durch einen faserverstärkten Verbundwerkstoff mit einer Faser, die in axialer Richtung abwechselnd Oberflächenbereiche großer Haftung, die im Bereich der Faser-Bruchfestigkeit liegt, und Oberflächenbereiche geringer bzw. keine Haftung mit der Matrix aufweist.

Sämtliche Oberflächenbereiche besitzen zweckmäßigerweise Ringform.

Die Oberflächenbereiche großer Haftung sind vorteilhafterweise so angeordnet, daß diese die Bruchfestigkeit der Faser in der jeweiligen Matrix voll übertragen können. Eine diesbezügliche optimierte Anordnung der Oberflächenbereiche wird experimentell ermittelt. Die Bereiche maximaler Faserhaftung sind mithin in der Lage, die Bruchkraft der Faser von einem «Haftring» zum nächsten zu übertragen.

Die dazwischenliegenden Bereiche minimaler Grenzflächenhaftung werden hingegen in ihrer Ausdehnung so bemessen, daß es statistisch unwahrscheinlich wird, daß die Haftzonen benachbarter Fasern nebeneinander zu liegen kommen bzw. sich in einer beliebigen Ebene überschneiden.

Ein Verfahren zur Herstellung einer erfindungsgemäßen Faser eines Verbundwerkstoffs kennzeichnet sich dadurch, daß auf einen Teil der haftaktiven Oberfläche der Faser haftungsvermindernde oder haftungsverhindernde Substanzen aufgetragen werden. Zwecks Einrichtung einer haftaktiven Oberfläche der Faser wird letztere entsprechend vorbehandelt.

Insbesondere werden durch Kontakt übertragbare Trennsubstanzen mit Hilfe von gegensinnig drehenden Benetzungsrollen oder -stempeln aufgebracht.

Der Auftrag einer Trennsubstanz kann aber auch durch Gasphasen- oder Plasmaabscheidung durch eine Filtermaske erfolgen, die ein oder mehrere Endlosbänder besitzt. Beispielsweise kann durch die Filter- oder Gittermaske eine Sperrschicht aufgedampft werden. Die Gitter- oder Filtermaske läuft hier als Endlosband mit der Abzugsgeschwindigkeit der Faser. Ist die Faser eine Siliziumcarbid-Faser, so kann die Trennschicht eine aufgebrachte Graphit-Trennschicht sein.

Ein anderes erfindungsgemäßes Verfahren zur Herstellung einer erfindungsgemäßen Faser für einen Verbundwerkstoff kennzeichnet sich durch Entfernung von auf der ursprünglichen Faseroberfläche befindlichen haftungsvermindernden oder haftungsverhindernden Substanzen, an den Stellen, an denen haftaktive Oberflächenbereiche entstehen sollen.

Beispielsweiser eignet sich hierfür eine Graphit-Trennschicht oder Polyurethanlack, wie in der GB-A-2 108 558 beschrieben. Es eignet sich jedoch auch jedes andere, dem Fachmann geläufige haftungsvermindernde Mittel.

Insbesondere werden hierbei mit Hilfe von gegensinnig drehenden Benetzungsrollen oder -stempeln durch Kontakt übertragbare Substanzen aufgebracht, die geeignet sind, die Trennsubstanz zu zerstören oder in eine Haftschicht umzuwandeln.

Das Entfernen der haftungsvermindernden oder haftungsverhindernden Substanzen kann auch mit Hilfe thermischer Energie erfolgen, z.B. durch Abflammen oder Laserstrahl.

Die Entfernung kann auch mit Hilfe von zerstörender oder abtragender Strahlung erfolgen, z.B. durch UV- oder Elektronen- oder Korpuskelstrahlung. Auch kann bei einer Siliziumcarbid-Faser die aufgebrachte Graphit-Trennschicht teilweise abgebrannt werden.

Die Applikation erfolgt vorzugsweise am Ende der eigentlichen Faserherstellung, sie kann aber auch während des Herstellprozesses integriert erfolgen oder zu einem beliebigen späteren Zeitpunkt.

Die Art der haftaktiven bzw. der haftvermindernden Oberflächenbehandlung hängt von der jeweiligen Faser-/Matrix-Kombination ab. Dabei ist darauf zu achten, daß die haftvermindernde Schicht weder Reaktionen mit der Faser noch mit der Matrix eingeht und möglichst niedrige Reibkoeffizienten erzeugt. Bei der haftaktiven Schicht kann es jedoch im Einzelfall durchaus angebracht sein, gerade eine solche kontrollierte Reaktion herbeizuführen, z.B. zwecks besserer Benetzung der Faseroberfläche.

Die Erfindung wird nachfolgend anhand von Ausführungsbeispielen unter Bezugnahme auf die Zeichnung näher beschrieben; es zeigen:

Fig. 1 eine bei einem faserverstärkten Verbundwerkstoff verwendete Faser,

Fig. 2 mehrere in einer Matrix angeordnete Fasern in einer bestimmten Relativanordnung zueinander,

Fig. 3 eine Faser während der Herstellung nach einem bestimmten Verfahren,

Fig. 4 eine Faser während der Herstellung nach einem anderen Verfahren, und

Fig. 5 eine Faser während der Herstellung nach einem dritten Verfahren.

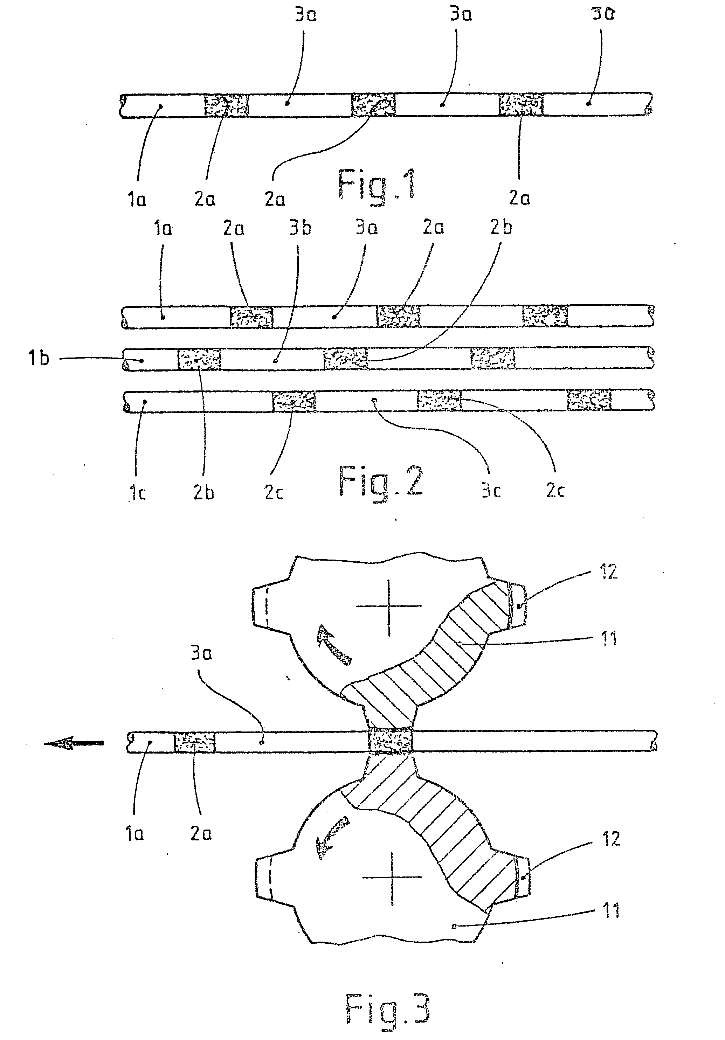

Die in Fig. 1 veranschaulichte Faser 1a ist Bestandteil eines faserverstärkten Verbundwerkstoffes, der aus einer Reihe von zumeist ausgerichteten Einzelfasern besteht, die in einer Matrix liegen. Zwischen Fasern und Matrix besteht gute und weniger gute oder keine Haftungsverbindung, wie nachfolgend noch beschrieben wird.

Jede einzelne Faser 1a umfaßt abwechselnd in axialer Richtung erstreckend ringförmige Oberflächenbereiche 2a mit maximaler Faserhaftung und längere ringförmige Oberflächenbereiche 3a geringer oder keiner Faserhaftung.

Im Verbund der Einzelfasern 1a, 1b und 1c der Fig. 2 sind die Oberflächenhaftungsbereiche 2a, 2b und 2c so angeordnet bzw. optimiert, daß die Bruchkraft der Faser von einem Haftring zum nächsten übertragen werden kann.

Die dazwischenliegenden Bereiche geringer oder minimaler Grenzflächenhaftung der Oberflächenbereiche 3a, 3b und 3c hingegen sind in ihrer axialen Längsausdehnung so bemessen, daß es statistisch unwahrscheinlich wird, daß die Haftzonen benachbarter Fasern nebeneinander zu liegen kommen bzw. sich in einer beliebigen Ebene überschneiden (vgl. Fig. 2). Auf diese Weise wird eine hinlänglich große Haftfestigkeit der Einzelfasern des faserverstärkten Verbundwerkstoffs erzielt. Gleichwohl erfolgt eine ausreichend große Rißstopperwirkung. Ein in einer (spröden) Matrix quer zur Faser verlaufender Riß in der Faser verursacht keine hohe lokale Kerbkonzentration. Auf diese Weise wird die Schlagzähigkeit des faserverstärkten Verbundwerkstoffs mit spröder Faser und spröder Matrix erhöht.

Die in den Figuren 1 und 2 gezeigten Fasern können auf unterschiedliche Weise hergestellt werden.

In Fig. 3 ist eine Einzelfaser 1a gezeigt, die in Pfeilrichtung gezogen wird. Mit gleicher Geschwindigkeit drehen sich gegensinnig drehende Benetzungsrollen oder -stempel 11, wobei die dazwischenliegende Einzelfaser 1a an erhabenen Stempelbereichen periodisch in Intervallen kontaktiert wird. Die erhabenen Stempelbereiche sind mit einem Ätzmittel 12 benetzt, so daß die Oberfläche der Faser 1a, die vor einer Behandlung vollständig mit einer haftungsinaktiven Trennschicht umschlossen ist, teilweise in einer Weise zerstört wird, daß haftungsaktive Oberflächenbereiche 2a in Abständen entstehen. Die zwischen zwei haftungsaktiven Oberflächenbereichen 2a ausgebildeten Oberflächenbereiche enthalten auch nach einer Ätzbehandlung ihre Trennschicht bei und bilden die haftungsverminderten Oberflächenbereiche 3a.

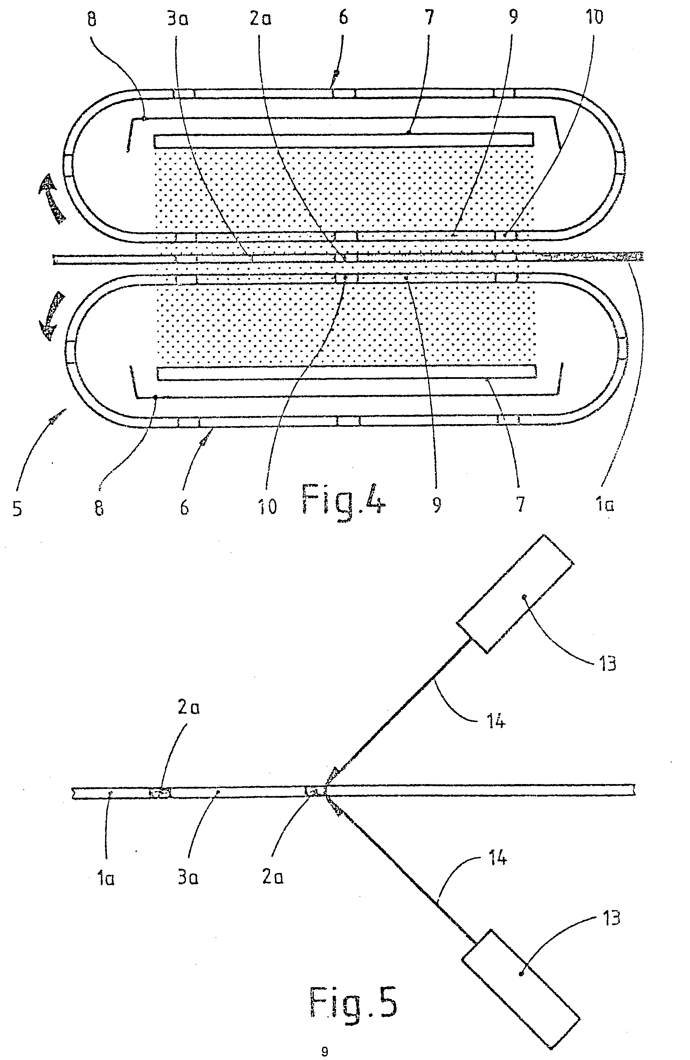

In Fig. 4 ist eine Einzelfaser 1a während eines anderen Herstellverfahrens gezeigt. Die ursprünglich vollständig haftungsaktive Oberfläche der Faser 1a wird teilweise mit einer Sperrschicht versehen, die durch Aufdampfen aufgetragen wird. Insbesondere ist eine Gitter- oder Filtermaske 5 vorgesehen, die zwei Endlosbänder 6 umfaßt, welche sich mit der Durchzugsgeschwindigkeit der Einzelfaser 1a in gleicher Richtung mit der Faser drehen, so daß ein Synchronlauf gewährleistet ist, der eine kontinuierliche Behandlung einer Endlosfaser ermöglicht.

Die Endlosbänder 6 besitzen Stege 10 und zwischen den Stegen vergleichsweise lange Maskenlöcher 9. Im Betrieb wird von in den Endlosbändern 6 angeordneten Verdampfern 7 Sperrschichtmaterial verdampft, das nur durch die Maskenlöcher 9 auf die Endlosfaser 1a einwirken kann, während im Bereich der Stege 10 die Faser unbehandelt bleibt. Mithin wird die Sperrschicht nur an den Oberflächenbereichen 3a der Faser 1a aufgedampft. Die durch die Stege 10 abgedeckten Oberflächenbereiche der Faser bleiben auch nach einer Behandlung haftungsaktiv und bilden die Oberflächenbereiche 2a mit großer Faserhaftung.

Die Rückseiten der Verdampfer 7 sind durch Schutzvorrichtungen in Form von Blechen 3 abgedeckt.

Das in Fig. 5 veranschaulichte Ausführungsbeispiel zeigt eine Einzelfaser 1a, die ursprünglich vollständig mit einer Antihaftschicht umgeben ist. Diese wird teilweise mittels Laserstrahlpulsen thermisch zerstört. Zwei Laser 13 sind hierbei in einer gegenüberliegenden Anordnung zur Einzelfaser gelegen, deren Laserstrahlen 14 gleichzeitig eine Trennschicht für einen haftungsaktiven Oberflächenbereich 2a auf dem gesamten Umfang abtragen.

**Patentansprüche**

1. Faserverstärkter Verbundwerkstoff mit Faser und Matrix, dadurch gekennzeichnet, daß die Faser (1a, 1b, 1c) in axialer Richtung abwechselnd Oberflächenbereiche (2a, 2b, 2c) großer Haftung, die im Bereich der Faser-Bruchfestigkeit liegt, und Oberflächenbereiche (3a, 3b, 3c) geringer bzw. keiner Haftung mit der Matrix aufweist.

2. Verbundwerkstoff nach Anspruch 1, dadurch gekennzeichnet, daß die Oberflächenbereiche (2a, 2b, 2c; 3a, 3b, 3c) Ringform besitzen.

3. Verbundwerkstoff nach Anspruch 1 oder 2, dadurch gekennzeichnet, daß die Oberflächenbereiche (2a, 2b, 2c) großer Haftung so angeordnet sind, daß diese die Bruchfestigkeit der Faser in der jeweiligen Matrix voll übertragen.

4. Verbundwerkstoff nach den Ansprüchen 1 bis 3, dadurch gekennzeichnet, daß die Oberflächenbereiche (3a) geringer bzw. keiner Haftung einer Faser (1a) so angeordnet sind bzw. sich axial so weit erstrecken, daß die Oberflächenbereiche (2b, 2c) großer Haftung von dieser Faser (1a) umgebenden gleichartigen Fasern (1b, 1c) nicht parallel oder überlappend liegen.

5. Verfahren zur Herstellung einer Faser eines Verbundwerkstoffes nach den Ansprüchen 1 bis 4, dadurch gekennzeichnet, daß auf einen Teil der haftaktiven Oberfläche der Faser (1a, 1b, 1c) haftungsvermindernde oder haftungsverhindernde Substanzen aufgetragen werden.

6. Verfahren nach Anspruch 5, dadurch gekennzeichnet, daß durch Kontakt übertragbare Trennsubstanzen mit Hilfe von gegensinnig drehenden Benetzungsrollen oder -stempeln aufgebracht werden.

7. Verfahren nach Anspruch 5, dadurch gekennzeichnet, daß der Auftrag der Trennsubstanz durch Gasphasen- oder Plasmaabscheidung durch eine Filtermaske (5) erfolgt, die ein oder mehrere endlose Bänder (6) umfaßt.

8. Verfahren zur Herstellung einer Faser eines Verbundwerkstoffs nach den Ansprüchen 1 bis 4, dadurch gekennzeichnet, daß abschnittsweise an den Stellen, an denen haftaktive Oberflächenbereiche (2a, 2b, 2c) entstehen sollen, auf der ursprünglichen Faseroberfläche befindliche haftvermindernde oder haftverhindernde Substanzen entfernt werden.

9. Verfahren nach Anspruch 8, dadurch gekennzeichnet, daß mit Hilfe von gegensinnig drehenden Benetzungsrollen oder -stempeln (11) durch Kontakt übertragbare Substanzen (12) aufgebracht werden, die geeignet sind, die Trennsubstanz zu zerstören oder in eine Haftschicht umzuwandeln.

10. Verfahren nach Anspruch 8, dadurch gekennzeichnet, daß die haftvermindernde(n) oder haftverhindernde(n) Substanz(en) mit Hilfe thermischer Energie entfernt wird (werden).

11. Verfahren nach Anspruch 8, dadurch gekennzeichnet, daß die haftvermindernde(n) oder Haftverhindernde(n) Substanz(en) mit Hilfe von zerstörender oder abtragender Strahlung unwirksam wird (werden).

**Claims**

1. Fibre-reinforced composite material comprising fibres and matrix, characterised in that in an axial direction, the fibre (1a, 1b, 1c) has alternate surface areas (2a, 2b, 2c) of great adhesion which lies in the region of the fibre rupture strength, and surface areas (3a, 3b, 3c) of minimal or no adhesion to the matrix.

2. Composite material according to Claim 1, characterised in that the surface areas (2a, 2b, 2c; 3a, 3b, 3c) are of annular shape.

3. Composite material according to Claim 1 or 2, characterised in that the surface areas (2a, 2b, 2c) of great adhesion are so disposed that they fully transmit the rupture strength of the fibres into the relevant matrix.

4. Composite material according to Claims 1 to 3, characterised in that the surface areas (3a) of minimal or no adhesion of a fibre (1a) are so disposed or extend sufficiently far axially that the surface areas (2b, 2c) of great adhesion of equivalent fibres (1b, 1c) which are enclosed by this fibre (1a) are not parallel or are overlapping.

5. Method of producing a fibre of a composite material according to Claims 1 to 4, characterised in that adhesion reducing or adhesion preventing substances are applied to a part of the adhesion-active surface of the fibre (1a, 1b, 1c).

6. Method according to Claim 5, characterised in that separating substances which are transmissible by contact are applied by means of oppositely rotating wetting rollers or stamps.

7. Method according to Claim 5, characterised in that the application of the separating substance takes place by gas phase or plasma deposition through a filter mask (5) comprising one or a plurality of endless belts (6).

8. Method of producing a fibre of a composite material according to Claims 1 to 4, characterised in that adhesion diminishing or adhesion preventing substances disposed on the original fibre surface are removed in portions from those places at which adhesion-active surface areas (2a, 2b, 2c) are intended to be formed.

9. Method according to Claim 8, characterised in that by means of oppositely rotating wetting rollers or stamps (11), contact-transmissible substances (12) are applied which are suitable for destroying the separating substance or converting it to an adhesive coating.

10. Method according to Claim 8, characterised in that the adhesion diminishing or adhesion preventing substance(s) is/are removed by means of thermal energy.

11. Method according to Claim 8, characterised in that the adhesion diminishing or adhesion preventing substance(s) is/are rendered ineffectual by the use of destructive or removing radiation.

**Revendications**

1. Matière composite renforcée de fibres avec fibre et matrice, caractérisée en ce que la fibre (1a, 1b, 1c) présente tour à tour en direction axiale des zones superficielles (2a, 2b, 2c) de grande adhérence à la matrice, qui se situe dans le domaine de la résistance à la rupture de la fibre, et des zones d'adhérence faible ou nulle à la matrice.

2. Matière composite selon la revendication 1, caractérisée en ce que les zones superficielles (2a, 2b, 2c; 3a, 3b, 3c) ont une forme annulaire.

3. Matière composite selon la revendication 1 ou 2, caractérisée en ce que les zones superficielles (2a, 2b, 2c) de grande adhérence sont disposées de telle sorte que celles-ci transmettent intégralement la résistance à la rupture de la fibre à la matrice considérée.

4. Matière composite selon les revendications 1 à 3, caractérisée en ce que les zones superficielles (3a) de résistance moindre ou nulle d'une fibre (1a) sont disposées de telle sorte ou s'étendent axialement suffisamment loin pour que les zones superficielles (2b, 2c) de grande adhérence de fibres (1b, 1c) identiques (1b, 1c) entourant cette fibre (1a), ne se placent pas parallèlement à celle-ci ou ne la recouvrent pas.

5. Procédé pour la fabrication d'une fibre d'une matrice composite selon les revendications 1 à 4, caractérisé en ce qu'il est appliqué des substances réduisant l'adhérence ou empêchant l'adhérence sur une partie de la surface favorisant l'adhérence de la fibre (1a, 1b, 1c).

6. Procédé selon la revendication 5, caractérisé en ce que les substances de séparation transférables par contact sont appliquées à l'aide de rouleaux ou de tampons d'humectation tournant en sens opposés.

7. Procédé selon la revendication 5, caractérisé en ce que l'application de la substance de séparation s'effectue par séparation en phase gazeuse ou en plasma au moyen d'un masque à filtre (5) qui comprend une ou plusieurs bandes sans fin.

8. Procédé pour la fabrication d'une fibre d'une matière composite selon les revendications 1 à 4, caractérisé en ce qu'il est retiré des substances réduisant l'adhérence ou supprimant l'adhérence qui se trouvent sur la surface d'origine de la fibre, ce décapage étant effectué par sections aux endroits où doivent être créées des zones superficielles favorisant l'adhérence (2a, 2b, 2c).

9. Procédé selon la revendication 8, caractérisé en ce qu'il est appliqué à l'aide de rouleaux ou de tampons d'humectation (11) des substances (12) transférables par contact qui conviennent pour détruire la substance de séparation ou pour la transformer en une couche adhérente.

10. Procédé selon la revendication 8, caractérisé en ce que la (les) substance(s) réduisant l'adhérence ou empêchant l'adhérence est (sont) retirée(s) à l'aide d'énergie thermique.

11. Procédé selon la revendication 8, caractérisé en ce que la (les) substance(s) réduisant l'adhérence ou empêchant l'adhérence est (sont) rendue(s) inopérante(s) à l'aide de rayons destructeurs ou décapants.

Fig.1

Fig.2

Fig.3

EP 0 134 416 B1

Fig.4

Fig.5

9